Europäisches Patentamt

European Patent Office

Office européen des brevets

(11) Publication number: **0 130 719**
**B1**

# EUROPEAN PATENT SPECIFICATION

(45) Date of publication of patent specification: **06.12.89**

(51) Int. Cl.⁴: **H 01 R 4/70, H 01 R 23/68**

(21) Application number: **84304015.5**

(22) Date of filing: **14.06.84**

(54) A connector and packaging structure for a semiconductor device employing the connector.

(30) Priority: **15.06.83 JP 105652/83**

(43) Date of publication of application:
**09.01.85 Bulletin 85/02**

(45) Publication of the grant of the patent:
**06.12.89 Bulletin 89/49**

(84) Designated Contracting States:
**CH DE FR LI NL**

(56) References cited:
**EP-A-0 081 372**
**EP-A-0 086 013**
**EP-A-0 123 376**
**GB-A-2 130 025**
**US-A-3 528 173**
**US-A-3 748 108**

(73) Proprietor: **HITACHI, LTD.**
**6, Kanda Surugadai 4-chome Chiyoda-ku**
**Tokyo (JP)**

(72) Inventor: **Minemura, Tetsuro**
**1-36-4-506 Nishinarusawa-cho**
**Hitachi-shi Ibaraki-ken (JP)**
Inventor: **Ando, Hisashi**
**5-16-5 Kanesawa-cho**
**Hitachi-shi Ibaraki-ken (JP)**
Inventor: **Kita, Yoshiaki**
**3337-128 Nakane**
**Katsuta-shi Ibaraki-ken (JP)**
Inventor: **Ikuta, Isao**
**2-26 Mimaya-cho Uchigou**
**Iwaki-shi Fukushima-ken (JP)**

(74) Representative: **Paget, Hugh Charles Edward**
**et al**
**MEWBURN ELLIS & CO. 2/3 Cursitor Street**
**London EC4A 1BQ (GB)**

Courier Press, Leamington Spa, England.

# EP 0 130 719 B1

## Description

The present invention relates to an electrical connector and to the packaging structure of a semiconductor device (LSI) employing such a connector.

A pin connector consists of a pin, a socket in which the pin is inserted, and a portion which packages the pin and socket. It is extensively used as an electrical or electronic connection component. With enhancement in the density of components in a computer, the importance of connectors is being recognized as a part of packaging techniques. A conventional pin connector has a structure wherein a socket portion is constructed of a spring member, which is principally made of a Cu-Be alloy, and a pin being inserted is connected by the spring force of the socket portion. The socket portion is arranged parallel with the direction of inserting the pin, and has a structure in which the pin is held between the springy parts of the spring member (or in the cylinder thereof). In recent years, with enhancements in the packaging densities of electric and electronic components and the density of a computer, it has been required to compact and miniaturize the connectors. Regarding this requirement, each of the conventional socket shapes poses a serious problem because, since a certain height is needed in the pin inserting direction, the wall of a socket package is thick. In addition, since the socket shape is complicated, manufacture is difficult upon miniaturization of the connector, and hence its shape needs to be simplified.

On the other hand, the enhanced density of a computer leads to an increase in the number of pins of the connector. If the number of pins to be inserted at one time is large, a force needed for joining the connector is increased. With a large number of pins, joining by manual force might be impossible with a connector of the prior-art structure based on the spring force. It has therefore been proposed to develop a low insertion force or null insertion force connector in which pins can be inserted or drawn out by a small force and which affords reliable connection in the joined state.

Japanese Laid-Open Patent Application No. 57—185680 discloses a connector wherein a hole is provided in the central part of a flat spring member, and a male contactor is inserted in the hole. However, it is very difficult to draw out the male contactor.

Japanese Laid-Open Patent Applications No. 58—71572 and No. 58—73973 show an electrical connector for a Josephson element semiconductor device, which connector is operated at a very low temperature by the deformation of a bimetal with a temperature change. The electrical connector employing bimetal, however, cannot achieve a great deformation unless it has a predetermined size, so that it cannot be miniaturized.

An electrical connector wherein a cylindrical socket is made of a shape memorizing alloy is taught in 'Kinzoku Binran (Handbook of Metals)' (fourth revised edition, issued in December 1982). This connector cannot be miniaturized.

One object of the present invention is to provide a connector in which contactors can be inserted and drawn out with low forces.

In essence, the invention proposes the use of a female contactor made at least partly of shape-memorizing alloy having a memorized shape at service temperature, such that the male contactor can be inserted at a different temperature, and on return to the service temperature, the male contactor is gripped by the tendency of the female contactor to return to its memorized shape.

The present invention thus comprises a connector comprising a female component having an insulating substrate having a plurality of pin-receiving holes, a desired first wiring pattern formed on the substrate and female contactors respectively located around the edges of the holes and each having an opening whose edge is located at least partly inwardly of the edge of the hole, said female contactors being electrically connected to said first pattern; and a male component comprising an insulating substrate having a desired second wiring pattern thereon and a plurality of male contactor pins fixed to the substrate and electrically connected to said second pattern, said pins being located in a position corresponding to the openings of said female contactors, wherein said female contactors are made of a thin layer of a shape memory alloy and the said edge of each of the female contactors has, before insertion of each of the male contactor pin, a shape memory such that the female contactor tends to return to a pin-gripping position when subjected to a temperature above the martensitic transformation temperature after insertion of the male contactor pin, by providing the part of the female contactor forming said hole with a shape memory based on a bending deformation so as to have a bent shape providing an opening larger than the dimensions of said male contactor pin in the contact region of said female and male contactors at a temperature not higher than the martensitic transformation temperature of said alloy, and so as to have a shape providing an opening smaller than the dimensions of said male contactor pin in the contact region in the parent phase transformation condition.

EP—A—0123376, which is prior art within the terms of Article 54(3) EPC discloses connectors of a shape-memorising material which return to a pin-gripping position above the martensitic temperature.

Preferably the part of the female contactor forming a hole is provided with a slit so as to be adapted for a bending deformation on insertion of a male contactor and has shape memory so as to be adapted for bending deformation in the same direction as that of the insertion of the male contactor, whereupon the female contactor is brought into contact with the male contactor.

Generally known as shape memorizing alloys are a Cu alloy containing 0—10% of Al and 10—40% of Zn, a Cu alloy containing 23—26% of Sn, a Cu alloy containing 12—15% of Al and 3—5% of Ni, an alloy

2

consisting of 42—48% of Ti and the balance of Ni, and so forth. Also, an Fe-Mn system, and Fe-Cr-Ni system, a U-Mo system an Mn-Cu system an Au-Cd system, etc. are usable.

The following table lists the compositions (weight %) and characteristics of the Cu-Al-Ni alloy and the Ni-Ti alloy by way of example. Since each of these alloys can memorize a final shape at temperatures below the $M_f$ point and a final shape at temperatures above the $A_f$ point, it cycles through these final shapes when subjected to these temperature cycles. It may accordingly be subjected to a shape memory so that a male contactor and a female contactor may be in contact with each other and make electrical conduction at a service temperature.

| Characteristics/ Compositions | Cu — 14.0% Al — 4.0% Ni | Ni — 44.3% Ti |
|---|---|---|
| Transformation temperature (°C) | | |
| $M_s$ | −124 | −23 |
| $M_f$ | −140 | −41 |
| $A_s$ | −117 | −12 |
| $A_f$ | −71 | 3 |
| Electric resistance ($\mu\Omega.cm$) | 11 | 70 |
| Rupture strength (kg/mm²) | 40 | 60 |

$M_s$: Parent phase → martensitic transformation starting temperature
$M_f$: Martensitic transformation finishing temperature
$A_s$: Martensite → parent phase transformation starting temperature
$A_f$: Parent phase transformation finishing temperature

The female contactor of the present invention is preferably made of a flat thin film, the thickness of which is preferably 100 µm or less.

In the female contactor in the present invention, the part forming the hole is preferably subjected to shape memory so as to be capable of bending deformation in the direction in which the female contactor comes into contact with the male contactor, when brought to the parent phase transformation temperature of the shape memorizing alloy. Further, the connector of the present invention is preferably designed so that in use the male contactor is inserted in the hole in a low temperature condition below the martensitic transformation temperature of the shape memorizing alloy, whereupon the connector has its temperature raised to the parent phase transformation temperature of the alloy so as to be returned into the original shape memorized. Since the male contactor is inserted with the hole of the female contactor expanded, insertion is permitted with a null insertion force, while during service of the connector, the contactors are rigidly connected as described before.

The hole portion of the female contactor in the present invention may be provided, in its party to come into contact with the male contactor, with a slit or opening which is narrower than a space to be occupied by the male contactor or with a slit which communicates with the hole portion. That is to say, it is preferable that the slit has the shape of the letter H, or that at least two slits are formed at equal intervals in the central part of the female contactor, or that the two or more slits are provided, meeting at the center of a circle. Further, the hole part is smaller than the occupying space of the male contactor in the contact area with this male contactor. Likewise to the foregoing, the male contactor is inserted into the female contactor at a temperature below the martensitic transformation temperature, whereupon the female contactor has its temperature raised to above the parent phase transformation temperature in the service temperature condition, thereby to provide a rigid connection.

Further, insulating substrates may be arranged on the top face and bottom face of the female contactor and are fastened to each other. With this connector, an increased number of pins can be realised at a higher density, and miniaturization is possible. Although the number of pins is 100—200 in the LSI packaging for the present-day computer, it is anticipated that this number will become 1000—2000 for a substrate of 10 cm square in the future. The present invention can cope with even such number of pins.

Furthermore, within the present invention, female contactors made of a shape memorizing alloy can be disposed on both the upper and lower surfaces of an insulating substrate, in similar manner to the foregoing. When the female contactor is disposed on only one surface of the insulating substrate, a male contactor may be disposed on the opposite surface. The female contactors, or the female contactor and male contactor, are electrically connected to each other.

As the insulating substrate, a multilayer print-wired substrate or a printed circuit board may be used. In correspondence with the holes for inserting the male contactors, the female contactors made of the shape memorizing alloy as proposed by the present invention can be disposed in electrical connection.

The female contactor of the present invention may be made of only a shape memorizing alloy in the form of a thin film. Alternatively, it may be fabricated as a composite member in which thin metal films are stacked and fixed together.

It is known from US—A—3748108 to provide a composite material in which a thin metallic film is bonded by adhesive to a shape memorizing alloy rod so to improve the heat conductivity of the composite structure compared to the rod.

The present invention, however, does not originate from considerations of heat conductivity, and is concerned particularly with a composite structure which can be used to form the female contactor as discussed above.

Therefore the present invention proposes:

1. A composite material in which thin metal films are stacked and bonded, wherein the thin metal films include a plurality of films of substantially pure copper, silver, gold or aluminium alternately with at least one film of a shape memorizing material.

2. A composite material in which thin metal films are stacked and bonded, wherein the thin metal films include a plurality of films of a ferromagnetic material alternately with at least one film of a shape memorizing material.

EP—A—0086013 which is prior art within the terms of Article 54(3) EPC discloses a layer of shape-memorizing material having layers of alloys i.e. metals different from the present invention on either side of the shape-memorizing material. Two shape-memorizing materials of different transformation temperatures may be stacked together.

It is very difficult to work a bulky shape memorizing alloy plastically into a thin film. In contrast, the thin film not greater than 0.1 mm in thickness can be formed by a method such as evaporation onto a metal substrate or by pouring the molten metal on the peripheral surface of a roll rotating rapidly, for quenching and solidification. When the molten metal is poured on the mirror-finished surface of a roll having a thermal conductivity of at least 42 W/m.°C (0.1 cal/cm.sec.°C) at room temperature, the cooling rate of the molten metal to solidification can be at or above $10^{3}$°C/sec. Thus, an alloy of very fine crystal grains is produced and can be plastically deformed, so that it can be worked even into a complicated shape. In order to form the thin film by a vapor process such as evaporation, the shape memorizing alloy needs to be formed in correspondence with holes which are provided in an insulating substrate. In this case, a metal foil is disposed on the insulating substrate in advance, and the shape memorizing alloy is deposited thereon. The alloy can be formed into a predetermined plane shape in correspondence with the holes of the insulating substrate, preferably by etching.

In one method of forming a connector of the present invention, a shape memorizing alloy is quenched from a vapor phase or liquid phase and is solidified on another metal member (substrate), whereby a composite member which exhibits the shape memorizing effect and also has the characteristics of the substrate (or a different phase) can be produced along with the substrate or the different phase which has already been solidified on the substrate. Suitable methods for quenching and solidification from the vapor or liquid phase are physical evaporation, chemical evaporation, molten metal quenching, flame spraying, etc. Physical evaporation may be a general evaporation process, a sputtering process, an ion plating process, etc. Chemical evaporation is a solidifying process which is based on a chemical reaction in a gaseous state. Molten metal quenching is a method in which a metal alloy in its molten state is poured onto a substrate so as to cool it by contact with the substrate, and it is generally known as a process for producing an amorphous alloy. In particular, single-roll and two-roll methods etc. are known for manufactuing a thin strap and a fine wire by pouring the molten metal onto the surface of a roll which rotates at high speed. Flame spraying is a method in which alloy powder in its molten state is atomized and solidified on a substrate.

With any of these methods, the alloy layer solidified on the substrate attains a good adhesion with the substrate or another metal which has already solidified on the substrate. The crystal grains of the layer are rendered very fine owing to the quenching and solidification. Thus, the stress concentration at a grain boundary due to a deformation is moderated by the fine nature of the crystal grains, and the ductility of a shape memorizing alloy which has hitherto shown poor ductility due to the coarsening of crystal grains can be improved. Furthermore, when a material which is higher in ductility than the shape memorizing alloy is used as the substrate, the fragility of the shape memorizing alloy can be compensated. Also, when a material having a proper springiness is selected for the substrate and is compounded with the shape memorizing alloy, the resultant substrate can be utilized as a spring member, and it is possible to control a temperature, a force etc. at or with which the shape memorizing effect appears.

Each of the shape memorizing alloys is a multielement alloy and is therefore inferior to a pure metal in conductivity. In the present invention, however, the shape memorizing alloy can be compounded with a substrate of high conductivity such as Cu, Al, Au or Ag, so that a shape memorizing compound member of favourable conductivity can be fabricated.

The present invention is applicable to the packaging structures of semiconductor devices.

In this aspect, the present invention subsists in a packaging structure for a semiconductor device wherein a multilayer print-wired substrate on which the semiconductor device is mounted is connected to a connector embodying the invention as defined above, and the connector is then mounted on a printed circuit board, wherein the connector is made of a shape memorizing alloy having a plurality of holes which are provided in correspondence with a plurality of male contactors disposed in the multilayer print-wired substrate as described above.

Furthermore, the present invention also subsists in a packaging structure for a semiconductor device having a multilayer print-wired substrate on which the semiconductor device is mounted, and a printed circuit board on which the substrate is mounted, wherein the printed circuit board is connected to a connector of the present invention, the connector comprising a female contactor made of a shape memorizing alloy having a plurality of holes which are provided in correspondence with a plurality of male contactors disposed in the multilayer print-wired substrate.

In addition, the present invention yet further in a packaging structure for a semiconductor device having a multilayer print-wired substrate on which the semiconductor device is mounted, and a printed circuit board on which the substrate is mounted, wherein the multilayer print-wired substrate is connected to a connector of the present invention as defined above, the connector comprising a female contactor made of a shape memorizing alloy having a plurality of holes which are provided in correspondence with a plurality of male contactors disposed in the semiconductor device.

The female contactor of the present invention provided in the connector, the printed circuit board or the multilayer print-wired substrate can be joined with the male contactors electrically and mechanically securely without soldering.

Embodiments of the invention will now be described by way of example with reference to the accompanying drawings, in which:—

Fig. 1 is sectional views generally illustrative of the connection and disconnection of a connector of the present invention utilizing a bidirectional shape memorizing effect;

Fig. 2 is plan views of various female contactors in embodiments of the present invention;

Fig. 3 is plan views illustrative of female contactors in other examples of the present invention, and the method of insertion and extraction of male contactors;

Fig. 4 is a perspective view showing the insertion and extraction of the male contactor in the embodiment of Fig. 5(b);

Fig. 5 shows connector apparatus illustrative of other examples of the present invention in each of which a female contactor is formed on an insulating substrate;

Fig. 6 shows perspective views illustrative of a manufacturing process in which female contactors of embodiments of the present invention are unitarily formed by bonding and chemical etching;

Fig. 7 shows sectional views of the connector components of embodiments of the present invention in each of which a female contactor is held between insulating substrates;

Figs. 8 and 9 are perspective views showing multi-pin connector structures which have the cross-sections in Fig. 7;

Fig. 10 is a perspective view showing LSI packaging which uses a connector of the present invention;

Figs. 11—14 are sectional views showing similar applications of electric connectors of the present invention in LSI packaging; and

Fig. 15 is a schematic view of a molten metal quenching apparatus for producing a shape memorizing composite material for use in embodiment of the present invention.

In the various figures, corresponding parts are indicated by the same reference numerals.

(Embodiment 1)

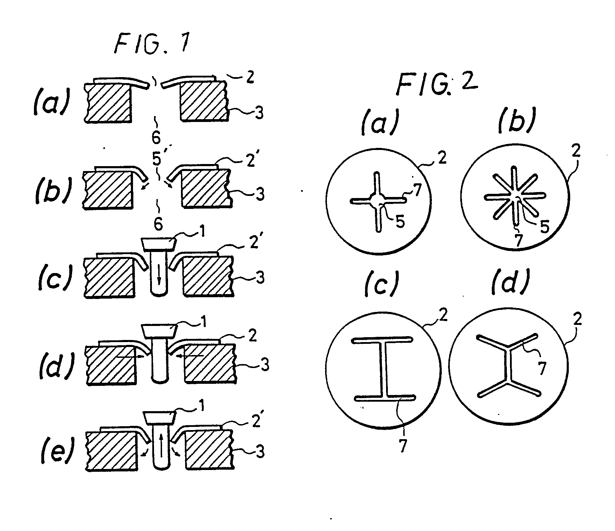

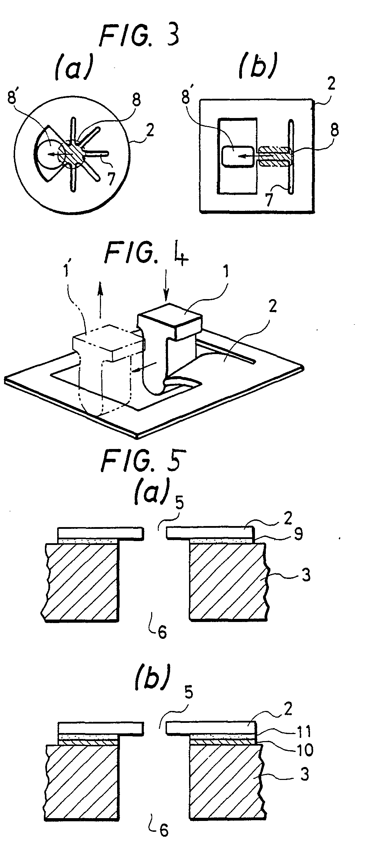

The embodiment shown in Fig. 1 exploits a reversible shape memory conforming to the transformation as shown in states (a) and (b). The shape memory is so made that the state (a) is established in the operating temperature condition of the connector and that the state (b) is established at or below the martensitic transformation temperature. When the connector is cooled to the martensitic transformation temperature, the gap of a pin inserting hole part 5' which is especially formed in the shape of a slit is opened by the shape memorizing effect. The pin is inserted therein as shown in (c). When the operating temperature condition is restored as shown in (d), the alloy returns into the parent phase state owing to the shape memorizing effect, to become hard and return into the (a) state, so that the female contactor and the pin are loaded with a joining force.

As illustrated in (e), when the joined connector is cooled to the condition of or below the martensitic transformation temperature again, the pin inserting hole part opens and the pin can be readily pulled out. In this manner, when the bidirectional shape memorizing effect is applied to the connector structure of the present invention, an electric connector of substantially null inserting and drawing-out forces can be realized. A shape memorizing alloy is difficult to work, as described before, so that even when the connector is intended to be miniaturized with the prior-art shape, working is difficult because of the complicated shape. In contrast, the structure of the present invention is simple, so that the application of the shape memorizing alloy is easy even with material which is difficult to work. This forms a great merit of the present invention.

(Embodiment 2)

In the present embodiment, the working of the shapes of female contactors was studied. A spring material made of a Cu-Be alloy and having a plate thickness of 0.08 mm (JIS C1700) was used for the female contactors, while molten-metal quenching ribbon materials of the Cu-Al-Ni alloy and Ni-Ti alloy indicated in the foregoing table were used for the shape memorizing alloys.

The quenched materials were prepared by a two-roll quenching apparatus, and were thin plates 0.06—0.09 mm thick and 5—10 mm wide. As manufacturing conditions, a nozzle made of silica and provided with a round port having a diameter of 0.8—1.0 mm was used, and a molten metal was spurted between rolls of Cu-Be (diameter: 120 mm) at a peripheral speed of about 10 m/s by Ar gas of high pressure (pressure: 1.0—1.5 kg/cm$^2$), thereby to be quenched and solidified. Various characteristics in the table were measured at the room temperature.

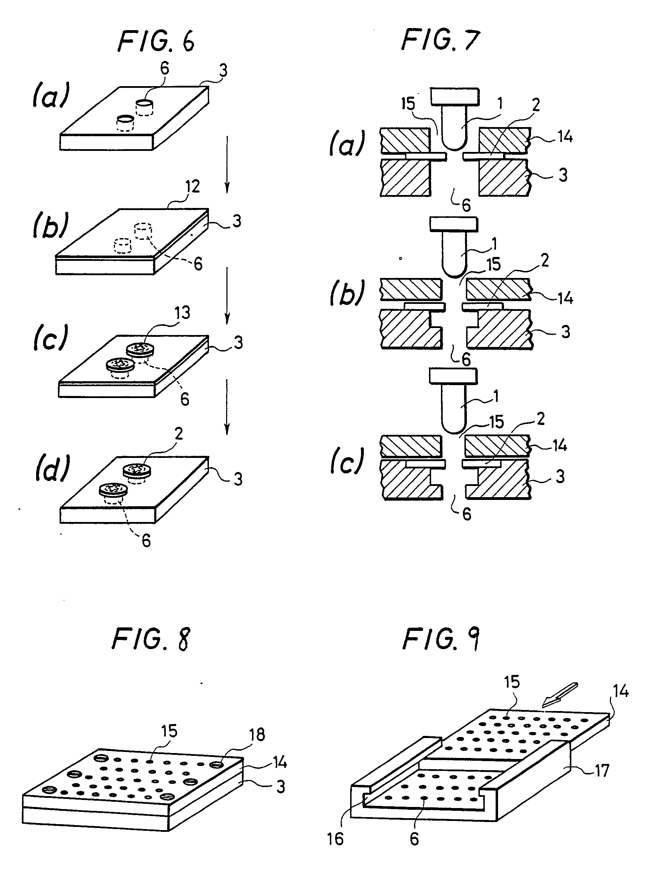

Fig. 2 shows plan views of four sorts of plane shapes of the female contactors 2 whose contours were worked circular from the alloy thin plates. (a) and (b) correspond to cases where the sections of male contactors are circular, and (c) and (d) cases where they are rectangular. For working, electrospark machining with a wire, chemical etching and punching were tried. In electrospark machining with wire, a hole for passing the wire was first drilled. The drill could work a diameter of 0.1 mm at the minimum. Used as the wire was a copper wire having a diameter of 0.1 mm at the minimum or a tungsten wire having a diameter of 0.05 mm. As a result, the width of a slit 7 was possible down to 0.1 mm. In addition, in the chemical etching, a slit shape printed on a photographic film was placed on a ribbon whose surface was coated with a photo-hardening resin, the ribbon was exposed to light, and only the unexposed resin of the surface corresponding to the slit portion was washed out. As a result, the ribbon fell into the state in which only the slit portion was not covered with the resin. This ribbon was immersed in a solution of ferric chloride for etching. Then, the width of the slit 7 could also be worked down to 0.1 mm. The punching was performed in the state in which the clearance was null, by the use of a metal mold made of die steel SKD11. Also with this method, the slit width could be worked to 0.1 mm at the minimum.

Fig. 3 shows plan views of the plane shapes of slits in a structure in which joined pin connectors can be pulled out easily. (a) shows a sectoral slit 7 into which three slits 7 in Fig. 2(b) are converted, and (b) shows a shape in which the lower half of the rectangle in Fig. 2(c) has been removed. The pin is inserted at the hatched part 8 in each figure, while it is drawn out by sliding it in the direction of arrow to 8' and thus releasing it from the joined state. The shape of (b) is cubically shown in Fig. 4.

It was attempted to insert and pull out pins on the basis of the bidirectional shape memorizing effect in the case of applying the shape memorizing alloy to female contactors. Slit shapes were those shown in Figs. 2(a) and (c). For bidirectional shape memory, the pin of 2 mm in diameter or having a rectangle of 1.2 × 1 mm was first inserted at the liquid nitrogen temperature so as to be worked intensely. This step was repeated 2—3 times for the shape memory. The pin of the above condition was inserted into the female contactor. Then, since a gap was formed between the pin and the joining part at the insertion or pulling-out stage, no force was necessary for the operation. It has been found that the connector in the joined state can endure up to a pulling-out force of 150 gr, and it has been acknowledged that a connector of low insertion force can be provided.

(Embodiment 3)

In the present embodiment, there was studied a method for fixing the female contactor worked in Embodiment 2, to a substrate having a pin inserting hole. The materials of the female contactors were the same as in Embodiment 2, and a glass epoxy resin, an epoxy resin and an alumina plate were used as the substrate materials. The working of the holes of these substrates was carried out with a conventional drill for the former and with a CO$_2$ laser for the latter. First, a fixing method by bonding was studied. Fig. 5 shows sectional views of female contactors of different bonding methods (a) illustrates a method in which the female contactor is fixed on the substrate simply by an adhesive 9. In general, any adhesive may be used as long as the bonding strength is sufficient. However, when a shape memorizing alloy is used, the adhesive must endure the heat cycle from the room temperature to the liquid nitrogen temperature. Ordinary organic adhesives cannot endure this cycle. An inorganic adhesive made of alumina or zirconia and water glass by way of example can endure the cycle. Further, when dried sufficiently, a silver paste afforded a satisfactory bonding strength of about 150 gr in terms of the stripping strength. With the alumina substrate, when the bonded structure is baked at 500—600°C for 1 h, the bonding strength is enhanced more by about 50%. Fig. 5(b) illustrates a method in which, for bonding enduring the heat cycle, a ceramics substrate is metalized and is provided with a plating layer 10, whereupon the female contactor is bonded by the use of a brazing material 11. In this example, the substrate was metalized with an Mo-Mn paste at 1100°C for 1 h and was subjected to Ni plating, whereupon the female contactor was bonded with a silver solder. Both the alloys attained good bonding of at least 300 gr in terms of the stripping strength.

Using such brazing bonding and the chemical etching of the foregoing embodiment, it was tried to directly form female contactors in hole portions on a substrate having the pin inserting holes. Used as the brazing materials were an indium solder, a silver solder, a lead solder, etc. Perspective views illustrative of the steps are shown in Fig. 6 (a) shows an alumina substrate 3 provided with holes 6. As shown in (b), a thin plate 12 of a Cu — 14 wt-% Al — 4 wt-% Ni alloy to form female contactors was bonded on the substrate by the brazing. As shown in (c), the thin plate was etched by the chemical etching so that parts to form the female contactors might be left around the holes. Under this state, masking was further changed, and the slits of pin joining parts were formed by etching. Since this process is possible, it has been found that a large number of female contactors corresponding to a large number of pins can be manufactured at one time.

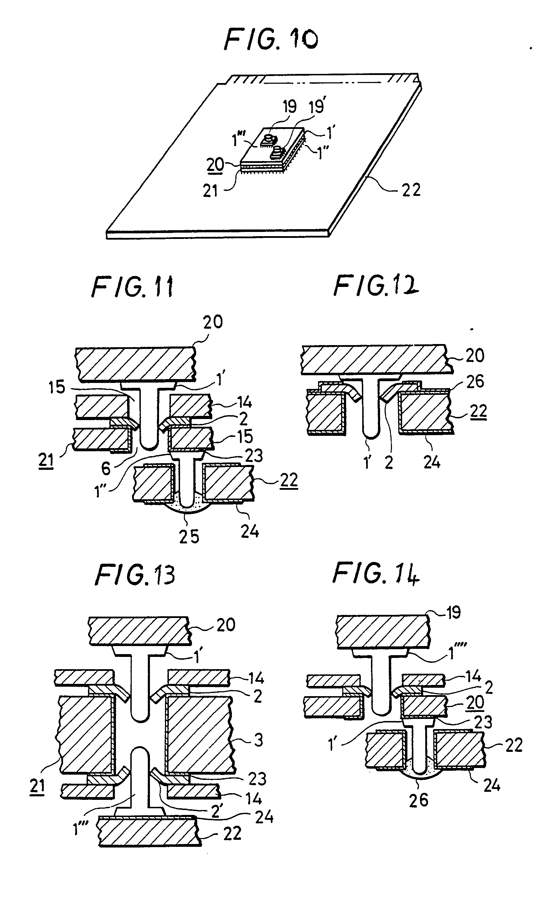

As another example of the fixing method, there was studied a system in which a female contactor is interposed between two substrates as shown in Fig. 7 (a) shows a case where the diameters of pin inserting holes in the upper and lower substrates are equal, (b) a case where upper and lower holes have diameters somewhat larger than the diameter of a pin and function as the guide of the pin, and (c) a case where, in order to bring the upper and lower substrates into perfect adhesion, the lower substrate is provided with a groove, in which the female contactor is arranged. These are somewhat complicated in structure as compared with the bonding method, but are high in reliability of fixing. In addition, after the female contactor was simply bonded as shown in Fig. 5(a), it had the substrate applied from above into the sandwiched structure, whereby fixing enduring even the heat cycle was realized. Perspective views of pin connectors employing this fixing system are shown in Figs. 8 and 9. Fig. 8 adopts the system of Fig. 7(b), and Fig. 9 the system of Fig. 7(c). The number of pins is 30, and the pitch interval between the pins is 2 inches. The pin is circular and 0.8 mm in diameter, and the slit shape of the female contactor is that of Fig. 2(b) having a length of 3 mm. The substrates are of an acrylic resin. The example of Fig. 8 has a structure in which the substrates are fixed by screws 18. The example of Fig. 9 has a structure in which guide slots 16 for inserting and fixing the upper substrate 15 between both the ends of the lower substrate 17 are provided, and the upper substrate is inserted laterally as indicated by arrow. In the case of Fig. 8, the female contactors need to be fixed on the lower substrate by simple bonding in order to fix their positions. In contrast, in the case of Fig. 9, the positions are fixed merely by placing the female contactors on the groove of the lower substrate. This brings the advantage that, even when the joining part of only one pin has a drawback such as damage, the female contactors can be immediately exchanged.

(Embodiment 4)

A Cu-Ni-Al-system shape memorizing alloy was stacked and compounded on Cu and Al foils placed on various insulating substrates having pin insertion holes, by sputtering. Oxygen-free copper (JIS, first class), electrolytic Ni (purity: 99.5%) and Al (purity: 99.8%) were mixed, and one charge of 2.5 kg was melted at a high frequency in vacuum of $10^{-3} - 10^{-2}$ Pa ($10^{-5} - 10^{-4}$ Torr). It was cast in a metal mold having a diameter of 95 mm. Discs 90 mm in diameter and 5 mm in thickness were cut out of a produced ingot by machining, and were used as sputtering targets. Sputtering equipment employed was of the bipolar DC — magnetron type. After the interior of a vessel in the equipment was evacuated to $4 \times 10^{-5}$ Pa ($3 \times 10^{-7}$ Torr), Ar was introduced up to a pressure of $4 \times 10^{-2}$ Pa (30 μmHg), and the alloy was deposited on one side of a Cu foil or Al foil (20 μm thick) under the sputtering conditions of an interelectrode distance of 60 mm, an Ar partial pressure of 0.67 Pa (5 mTorr) and an electric power of 200 W. The sputtering time-dependency of the thickness of a sputtered film at the time at which the alloy was deposited on the substrate increased substantially rectilinearly with time. The alloy could be stacked near to 50 μm in 4.5 h, and was in favorable close contact with the Al foil even in the stacked state left intact. On the Cu foils, substantially the same time-dependency of the thickness of the sputtered film and films of high adhesion were attained. The martensitic transformation starting temperature ($M_s$) of these sputtered films was −123°C as the result of the four-terminal measurement of an electric resistance. Accordingly, the shape memorizing alloy exhibits a remarkable shape memorizing effect between liquid nitrogen and room temperatures, and it can be employed for a member which is operated between these temperatures.

When the quenched structure was observed with a scanning electron microscope, a layer of very fine crystals about 2—3 μm in diameter was formed at the surface and moderated the stress concentration on a grain boundary against a bending deformation, so that the bending ductility was enhanced.

Using the substrates in which the shape memorizing alloy was deposited on the Al and Cu foils in this manner, female contactors were manufactured by the process based on the chemical etching as shown in Fig. 7. A good shape memorizing effect was noted when the shape memorizing alloy was stacked to thicknesses of at least about 2 μm in the composite material with the Al foils being 50 μm thick and to thicknesses of at least about 4 μm in the composite material with the Cu foils. In addition, the composite materials in which both the constituents were in close contact with each other were formed.

In the present embodiment, a female contactor which was 1 mm in the outside diameter, 0.5 mm in the diameter of the central hole part 5, and 3 mm and 0.2 mm in the length and width of the slit 7 respectively was produced by chemical etching. A pin having a diameter of 0.8 mm was inserted therein in liquid nitrogen, to perform the intense working of bending in which the central hole part 5 was opened more. Subsequently, the connector was restored to the room temperature. Then, it was confirmed that the contact part of the female contactor returned into the original flat state. Next, the female contactor was put in the liquid nitrogen again, and the pin was similarly inserted. Then, the pin could be inserted with effectively no resistance. When the pin was drawn out at the room temperature, the drawing-out force was about 100 gr. Therefore, a connector of null insertion force is provided.

(Embodiment 5)

The present embodiment exemplifies application to the packaging of an LSI. Fig. 10 is a perspective view of a printed circuit board 22 on which LSI packages 19, 19' employing the electric connector of the present invention are installed. The LSIs 19, 19' are soldered to a ceramic multilayer print-wired substrate 20, and are further connected to the connector 21 of the present invention. The connector of the present invention is joined to a printed circuit board 22 by a solder 25.

Fig. 11 is a setup view of a section of the state in which the connector of the present invention is placed on the printed circuit board 22, and the multilayer print-wired substrate 20 is placed on the connector. In the connector of the present invention, a conductive film 23 which electrically connects a female contactor 2 and a pin 1'' inserted in the printed circuit board 22 is provided on a hole part 6 for inserting the pin 1' of a ceramic insulating substrate 15, and the female contactor 2 made of a shape memorizing alloy is fixed on the conductive film by an upper ceramics insulating substrate 14. The female contactors 2 of the present invention used here are a thin film formed by molten-metal quenching, evaporation, sputtering or the like as described before, and the thin film is stuck on an insulating substrate and etched into a predetermined shape as described before.

Fig. 12 is a sectional view of an example in which the female contactor 2 of the present invention is formed on the printed circuit board 22, and the multilayer print-wired substrate 20 is placed thereon. The printed circuit board 22 is formed with wiring leads by an ordinary method, and the female contactor 2 made of a shape memorizing alloy is formed on the hole part thereof for inserting a pin 1' similarly to the foregoing. The wiring film 24 and the female contactor 2 are joined by a conductive paste or the like. The female contactor 2 is coated with a resin as indicated at numeral 26.

In order to form the female contactors 2 in the vapor phase by sputtering, evaporation or the like in the case of Fig. 11 or 12, the pin inserting holes need to be closed up. Therefore, a metal foil is fastened on the insulating substrate 3 or the printed circuit board 22, and the shape memorizing alloy is formed thereon and is etched into the desired shape.

Fig. 13 is a sectional view showing another example of the electric connector of the present invention which is also suited to the packaging of an LSI. Structurally, female contactors 2, 2' made of a shape memorizing alloy are disposed on both the surfaces of an insulating substrate 3. A conductive film 23 is provided so that the female contactors 2, 2' may be electrically connected with each other. A pin 1' disposed on a multilayer print-wired substrate 20 is inserted in the female contactor 2, while a pin 1'', disposed on a printed circuit board 22 is inserted in the female contactor 2'. Thin films to construct the female contactors can be manufactured by various methods as described before. In order to form the shape memorizing alloy in the vapor phase by sputtering, evaporation or the like, the pin inserting holes may be closed up with metal foils as described before.

According to the present embodiment, pins can be inserted with a low insertion force by subjecting the female contactors to shape memory so as to widely expand the spaces of the hole parts thereof in the soft martensite state or at a low temperature. Moreover, the female contactors can be produced by the etching technique. It is therefore possible to provide an electric connector which can be miniaturized and which has a high productivity owing to unitary forming.

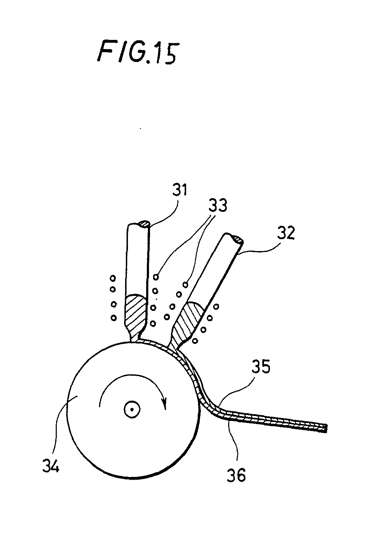

Fig. 14 is a sectional view showing an LSI packaging structure in which a multilayer print-wired substrate 20 is provided with the connector 2 of the present invention employing a shape memorizing alloy. As in the foregoing, the connector 2 of a thin film can be formed on the multilayer print-wired substrate 20 by the use of a thin band produced by melting and quenching the shape memorizing alloy. Alternatively, the thin film is directly formed on the multilayer print-wired substrate fabricated by an ordinary method, in electrical connection therewith by a process for the formation in the vapor phase such as evaporation or sputtering, whereupon it is formed into a desired shape by the etching technique.

(Embodiment 6)

A Cu-Ni-Al-system shape memorizing alloy was stacked and compounded on various substrates (Cu, Al) by sputtering. The alloy had a composition of Cu — 4% Ni — 14% Al (by weight). Oxygen-free copper (JIS, first class), electrolytic Ni (purity: 99.5%) and Al (purity: 99.8%) were mixed, and one charge of 2.5 kg was melted at a high frequency in a vacuum of $10^{-3}$—$10^{-2}$ Pa ($10^{-5}$—$10^{-4}$ Torr). It was cast in a metal mold having a diameter of 95 mm. Discs 90 mm in diameter and 5 mm in thickness were cut out of a produced ingot by machining, and were used as sputtering targets. A sputtering equipment employed was of the bipolar DC — magnetron type. After the interior of a vessel in the equipment was evacuated to $4 \times 10^{-5}$ Pa ($3 \times 10^{-7}$) Torr, Ar was introduced up to a pressure of $4 \times 10^{-2}$ Pa (30 μmHg), and the alloy was deposited on one side of a Cu foil or Al foil (20 μm thick) under the sputtering conditions of an interelectrode distance of 60 mm, an Ar partial pressure of 1.3 Pa ($10^{-2}$ Torr) and an electric power of 200 W.

The alloy was deposited on the substrate made of the Al foil, by sputtering. The thickness of the shape memorizing alloy film increases substantially rectilinearly with the sputtering time. The alloy can be stacked near to 50 μm in 4.5 h., and is in favorable close contact with the Al foil even in the stacked state left intact. On the Cu foils, substantially the same time-dependency of the thickness of the sputtered film and films of high adhesion were attained. The martensitic transformation starting temperature ($M_s$) of these

sputtered films was −123°C as the result of the four-terminal measurement of an electric resistance. Accordingly, the shape memorizing alloy exhibits a remarkable shape memorizing effect between liquid nitrogen and room temperatures, and it can be employed for a member which is operated between the temperatures. When the quenched structure was observed with a scanning electron microscope, a layer of very fine crystals about 2—3 μm in diameter was formed at the surface and moderated the stress concentration on a grain boundary against a bending deformation, so that the bending ductility was enhanced.

Test pieces each being 5 mm wide and 50 mm long were cut out of the composite materials in which the alloy was sputtered and deposited on the Al and Cu foils to various thicknesses in this manner, and the presence or absence of the phenomenon of the shape memorizing effect therein was examined. In the shape memorizing alloy film, the state formed by the sputtering is stored. Accordingly, a desired shape can be stored in conformity with the shape of the film. The test piece was bent to a radius of 3 mm so that the side of the shape memorizing alloy layer might be subjected to a tensile stress. In that state, the test piece was immersed in liquid nitrogen and was plastically deformed. Thereafter, the test piece was returned to the room temperature, and the shape recovery state thereof was examined. As a result, good shape recovery was noted when the shape memorizing alloy was stacked to thicknesses of at least about 2 μm as indicated in a hatched part in the composite material with the Al foils being 50 μm thick and to thicknesses of at least about 4 μm in the composite material with the Cu foils. Thus, according to the present example, the sputter-deposited shape memorizing alloy favourably adhered to the substrates, and the composite materials exhibited good shape memorizing effects. When female contactors having the shape in Fig. 3(a) were formed by electrospark machining, chemical etching and punching by the use of these composite materials, favorable shape memorizing effects were attained.

(Embodiment 7)

A shape memorizing composite material was produced by compounding Cu and a Cu-based shape memorizing alloy by the use of a method of quenching molten metals as shown in Fig. 15. The Cu was inserted in a nozzle 31 and the Cu — 4% Ni — 14% Al alloy in a nozzle 32 and they were molten by a high frequency coil 33. Using argon gas under a high pressure, the molten metals were spurted on a roll 34 rotating at high speed, to be quenched and solidified. A composite ribbon of the Cu and the shape memorizing alloy, in which the Cu-based shape memorizing alloy was stacked on a Cu ribbon, was fabricated by this method. The nozzles 31 and 32 were made of transparent silica. At the tips, the nozzle 31 was provided with a slit of 0.5 × 5 mm, and the nozzle 32 with an aperture 0.5 mm in diameter. The distance between the two nozzles was set at 120 mm. Oxygen-free copper (JIS, first class) was employed as the Cu. The roll used was made of tool steel and had a diameter of 300 mm, and was set at a rotational frequency of 2000 r.p.m. The gap between each nozzle and the roll was set at 0.02 mm, and the molten metals were spurted under a jet gas pressure of 0.4 kg/cm². In the fabricated composite material, Cu was 50 μm thick, and Cu-Al-Ni was 90 μm thick, and they adhered favorably. When the shape memorizing effect was assessed by the method indicated in Embodiment 6, good shape recovery was noted. The boundary between the compounded ribbons could not be observed because of the absence of any means for detecting the alloy phase. However, the atoms were physically joined in close contact with each other so as to have a force enough to endure a bimetal-like action. Further, when female contactors having the shape in Fig. 3(a) were formed by electrospark machining etc., favorable connections as connectors were achieved.

**Claims**

1. A connector comprising a female component having an insulating substrate (3) having a plurality of pin-receiving holes (6), a desired first wiring pattern formed on the substrate (3) and female contactors (2) respectively located around the edges of the holes and each having an opening whose edge is located at least partly inwardly of the edge of the hole, said female contactors being electrically connected to said first pattern; and a male component comprising an insulating substrate (20) having a desired second wiring pattern thereon and a plurality of male contactor pins (1) fixed to the substrate and electrically connected to said second pattern, said pins (1) being located in a position corresponding to the openings of said female contactors (2), wherein said female contactors (2) are made of a thin layer of a shape memory alloy and the said edge of each of the female contactors has, before insertion of each of the male contactor pin, a shape memory such that the female contactor tends to return to a pin-gripping position when subjected to a temperature above the martensitic transformation temperature after insertion of the male contactor pin (1), by providing the part of the female contactor (2) forming said hole with a shape memory based on a bending deformation so as to have a bent shape providing an opening larger than the dimensions of said male contactor pin (1) in the contact region of said female and male contactors at a temperature not higher than the martensitic transformation temperature of said alloy, and so as to have a shape providing an opening smaller than the dimensions of said male contactor pin (1) in the contact region in the parent phase transformation condition.

2. A connector according to claim 1, which is adapted to be used by insertion of male contactor pins (1) in said holes of said female contactors (2) at a temperature not higher than the martensitic transformation temperature of said alloy, whereafter the connector is held at the parent phase transformation temperature of said alloy.

3. A connector according to claim 1 or claim 2, wherein said hole in the female contactor is a slit of a width smaller than the dimensions of said male contactor pin (1) in the contact region between said female and male contactors.

4. A connector according to any one of the preceding claims, wherein said female contactors (2) are provided on one side of said insulating substrate (3), while provided on the opposite side of the substrate are a plurality of male contactor pins of a further similar connector having a female component with a plurality of female contactors of shape memory alloy as aforesaid.

5. A connector according to any one of claims 1 to 3, wherein said female contactors (2) are provided in sets on both upper and lower surfaces of the substrate (3) and are electrically connected through conductive films formed on said holes provided in said substrate (3), there being two male components adapted to be received by the respective sets of female contactors.

6. A packaging structure for a semiconductor device wherein a multilayer print-wired substrate on which the semiconductor device is mounted is connected to a connector which is mounted on a printed circuit board, wherein the connector is as defined in any one of claims 1 to 5, with the male contactor pins (1) disposed on said multilayer print-wired substrate.

7. A packaging structure for a semiconductor device wherein a multilayer print-wired substrate on which the semiconductor device is mounted is connected to a connector, which is mounted on a printed circuit board, wherein the connector is as defined in any one of the claims 1 to 5, wherein said printed circuit board is the said insulating substrate having the female contactors (2) and the male contactor pins (3) are disposed on said multilayer print-wired substrate.

8. A packaging structure for a semiconductor device wherein a multilayer print-wired substrate on which the semiconductor device is mounted is connected to a connector, and the connector is mounted on a printed circuit board, wherein the connector is as defined in any one of claims 1 to 5, with said multilayer print-wired substrate being said insulating substrate having the female contactors (2) and the male contactor pins (3) disposed on said semiconductor device.

9. A composite material in which thin metal films are stacked and bonded, wherein the thin metal films include a plurality of films of substantially pure copper, silver, gold or aluminium alternately with at least one film of a shape memorizing material.

10. A composite material in which thin metal films are stacked and bonded, wherein the thin metal films include a plurality of films of a ferromagnetic material alternately with at least one film of a shape memorizing material.

11. A material according to claim 9 or claim 10, wherein a plurality of shape memorizing materials of unequal transformation points are stacked.

**Patentansprüche**

1. Verbinder, aufweisend eine Buchsenkomponente mit einem isolierenden Substrat (3) mit einer Vielzahl von Stift-Aufnahmelöchern (6), einem auf dem Substrat (3) gebildeten beliebigen ersten Verdrahtungsmuster und Aufnahme-Kontaktelementen (2), die jeweils um die Ränder der Löcher herum angeordnet sind und jeweils eine Öffnung haben, deren Rand zumindest teilweise innerhalb des Randes des Loches liegt, wobei die Aufnahme-Kontaktelemente elektrisch mit dem ersten Muster verbunden sind; und eine Steckerkomponente, aufweisend ein isolierendes Substrat (20) mit einem darauf vorgesehenen beliebigen zweiten Verdrahtungsmuster und eine Vielzahl von Steck-Kontaktstiften (1), die auf dem Substrat befestigt und elektrisch mit dem zweiten Muster verbunden sind, wobei diese Stifte (1) an einer Position angeordnet sind, die den Öffnungen der Aufnahme-Kontaktelemente (2) entspricht, wobei die Aufnahme-Kontaktelemente (2) aus einer dünnen Schicht einer Formgedächtnislegierung hergestellt sind und der Rand von jedem der Aufnahme-Kontaktelemente vor Einführung des jeweiligen Steck-Kontaktstiftes ein derartiges Formgedächtnis hat, daß das Aufnahme-Kontaktelement dazu tendiert, in eine Stift-Greifposition zurückzukehren, wenn es nach Einführung des Steck-Kontaktstiftes (1) einer Temperatur über der martensitischen Transformationstemperatur ausgesetzt wird, indem der Teil des Aufnahme-Kontaktelements (2), der das Loch mit einem Formgedächtnis auf Grundlage einer Biegedeformation bildet, so vorgesehen wird, daß er bei einer Temperatur nicht über der martensitischen Transformationstemperatur der Legierung eine gebogene Form hat, die eine Öffnung größer als die Abmessungen des Steck-Kontaktstiftes (1) im Kontaktbereich der Aufnahme- und der Steck-Kontaktelemente liefert, und daß er unter der Ausgangs-Phasentransformationsbedingung eine Form hat, die eine Öffnung kleiner als die Abmessungen des Steck-Kontaktstiftes (1) in dem Kontaktbereich liefert.

2. Verbinder nach Anspruch 1, der für eine Verwendung durch Einführung von Steck-Kontaktstiften (1) in die Löcher der Aufnahme-Kontaktelemente (2) bei einer Temperatur nicht über der martensitischen Transformationstemperatur der Legierung ausgelegt ist, wonach der Verbinder auf der Ausgangs-Phasentransformationstemperatur der Legierung gehalten wird.

3. Verbinder nach Anspruch 1 oder Anspruch 2, wobei das Loch in dem Aufnahme-Kontaktelement ein Schlitz mit einer Breite kleiner als die Abmessungen des Steck-Kontaktstiftes (1) in dem Kontaktbereich zwischen den Aufnahme- und Steck-Kontaktelementen ist.

4. Verbinder nach einem der vorhergehenden Ansprüche, wobei die Aufnahme-Kontaktelemente (2) auf einer Seite des isolierenden Substrats (3) vorgesehen sind, während auf der gegenüberliegenden Seite des Substrats eine Vielzahl von Steck-Kontaktstiften eines weiteren ähnlichen Verbinders vorgesehen ist, der eine Buchsenkomponente mit einer Vielzahl von Aufnahme-Kontaktelementen der Formgedächtnislegierung hat, wie oben beschrieben.

5. Verbinder nach einem der Ansprüche 1 bis 3, wobei die Aufnahme-Kontaktelemente (2) in Sätzen sowohl auf der oberen als auch auf der unteren Oberfläche des Substrats (3) vorgesehen sind und über leitfähige Filme, die auf den in dem Substrat (3) vorgesehenen Löchern gebildet sind, elektrisch verbunden sind, wobei es zwei Steckerkomponenten gibt, die für die Aufnahme durch die entsprechenden Sätze von Aufnahme-Kontaktelementen ausgelegt sind.

6. Gehäusestruktur für eine Halbleitervorrichtung, wobei ein Mehrschicht-Druckschaltungssubstrat, auf dem die Halbleitervorrichtung montiert ist, mit einem Verbinder verbunden ist, der auf einer Druckschaltungsplatte montiert ist, wobei der Verbinder einem der Ansprüche 1 bis 5 entspricht, wobei die Steck-Kontaktstifte (1) auf dem Mehrschicht-Druckschaltungssubstrat angeordnet sind.

7. Gehäusestruktur für eine Halbleitervorrichtung, wobei ein Mehrschicht-Druckschaltungssubstrat, auf dem die Halbleitervorrichtung montiert ist, mit einem Verbinder verbunden ist, der auf einer Druckschaltungsplatte montiert ist, wobei der Verbinder einem der Ansprüche 1 bis 5 entspricht, wobei die Druckschaltungsplatte des genannte isolierende Substrat mit den Aufnahme-Kontaktelementen (2) ist und die Steck-Kontaktstifte (3) auf dem Mehrschicht-Druckschaltungssubstrat angeordnet sind.

8. Gehäusestruktur für eine Halbleitervorrichtung, wobei ein Mehrschicht-Druckschaltungssubstrat, auf dem die Halbleitervorrichtung montiert ist, mit einem Verbinder verbunden ist und der Verbinder auf einer Druckschaltungsplatte montiert ist, wobei der Verbinder einem der Ansprüche 1 bis 5 entspricht, wobei das Mehrschicht-Druckschaltungssubstrat das isolierende Substrat mit den Aufnahme-Kontaktelementen (2) ist und die Steck-Kontaktstifte (3) an der Halbleitervorrichtung angeordnet sind.

9. Verbundmaterial, in dem dünne Metallfilme geschichtet und verbunden sind, wobei die dünnen Metallfilme mehrere Filme aus im wesentlichen reinem Kupfer, Silber, Gold oder Aluminium abwechselnd mit zumindest einem Film aus einem Formgedächtnismaterial enthalten.

10. Verbundmaterial, in dem dünne Metallfilme geschichtet und verbunden sind, wobei die dünnen Metallfilme mehrere Filme aus einem ferromagnetischen Material bawechselnd mit zumindest einem Film aus einem Formgedächtnismaterial enthalten.

11. Material nach Anspruch 9 oder Anspruch 10, wobei mehrere Formgedächtnismaterialien mit ungleichen Transformationspunkten geschichtet sind.

## Revendications

1. Connecteur comportant un élément femelle possédant un substrat isolant (3) ayant une pluralité de trous (6) de réception de broches, une première configuration de câblage désirée réalisée sur le substrat (3) et des contacts femelles (2) respectivement disposés autour des bords des trous et possédant chacun une ouverture dont le bord est situé au moins partiellement à l'intérieur du bord du trou, lesdits contacts femelles étant électriquement reliés à ladite première configuration; et un élément mâle comportant un substrat isolant (20) portant une seconde configuration de câblage désirée et une pluralité de broches (1) de contact mâles fixées au substrat et électriquement reliées à ladite seconde configuration, lesdites broches (1) étant disposées dans une position correspondant aux ouvertures desdits contacts femelles (2), dans lequel lesdits contacts femelles (2) sont réalisés en une couche mince d'un alliage doué de mémoire de forme et ledit bord de chacun des contacts femelles possède, avant introduction de chaque broche de contact mâle, une mémoire de forme telle que le contact femelle tend à reprendre une position de serrage de broche lorsqu'il est soumis à une température supérieure à la température de transformation martensitique après introduction de la broche (1) de contact mâle, en munissant la partie du contact femelle (2) formant ledit trou d'une mémoire de forme basée sur une déformation par flexion de manière à obtenir une forme courbée assurant une ouverture plus grande que les dimensions de ladite broche (1) de contact mâle dans la région de contact desdits contacts femelle et mâle à une température non supérieure à la température de transformation martensitique dudit alliage, et de manière à obtenir une forme assurant une ouverture plus petite que les dimensions de ladite broche (1) de contact mâle dans la région de contact dans l'étant de transformation de phase de base.

2. Connecteur selon la revendication 1, qui est destiné à être utilisé par introduction de broches (1) de contact mâle dans lesdits trous desdits contacts (2) femelles à une température non supérieure à la température de transformation martensitique dudit alliage, après quoi le connecteur est maintenu à la température de transformation de phase de base dudit alliage.

3. Connecteur selon la revendication 1 ou la revendication 2, dans lequel ledit trou dans le contact femelle est une fente de largeur inférieure aux dimensions de ladite broche (1) de contact mâle dans la région de contact entre lesdits contacts femelle et mâle.

4. Connecteur selon l'une quelconque des revendications précédentes, dans lequel lesdits contacts femelles (2) sont prévus sur un côté dudit substrat isolant (3), tandis que sur le côté opposé du substrat est prévue une pluralité de broches de contact mâle d'un autre connecteur similaire possédant un élément femelle avec une pluralité de contacts femelles en alliage doué de mémoire de forme comme précité.

5. Connecteur selon l'une quelconque des revendications 1 à 3, dans lequel lesdits contacts femelles (2) sont prévus en jeux sur les deux surfaces supérieure et inférieure du substrat (3) et sont électriquement reliés par l'intermédiaire de pellicules conductrices réalisées sur lesdits trous prévus dans ledit substrat (3), deux éléments mâles étant agencés pour être reçus par les jeux respectifs de contacts femelles.

6. Structure de conditionnement pour un dispositif à semiconducteurs dans lequel un substrat à couches multiples à câblage imprimé sur lequel est monté le dispositif à semiconducteurs est relié à un connecteur qui est monté sur un panneau de circuit imprimé, dans laquelle le connecteur est tel que défini dans l'une quelconque des revendications 1 à 5, les broches (1) de contact mâle étant disposées sur ledit substrat à couches multiples à câblage imprimé.

7. Structure de conditionnement pour un dispositif à semiconducteurs, dans laquelle un substrat à couches multiples à câblage imprimé sur lequel est monté le dispositif à semiconducteurs est relié à un connecteur, qui est monté sur un panneau de circuit imprimé, dans laquelle le connecteur est tel que défini selon l'une quelconque des revendications 1 à 5, dans laquelle ledit panneau de circuit imprimé est ledit substrat isolant possédant les contacts femelles (2) et les broches (3) de contact mâle sont disposées sur ledit substrat à couches multiples à câblage imprimé.

8. Structure de conditionnement pour un dispositif à semiconducteurs, dans laquelle un substrat à couches multiples à câblage imprimé, sur lequel est monté le dispositif à semiconducteurs, est relié à un connecteur, et le connecteur est monté sur un panneau de circuit imprimé, dans laquelle le connecteur est tel que défini dans l'une quelconque des revendications 1 à 5, ledit substrat à couches multiples à câblage imprimé étant le substrat isolant possédant les contacts femelles (2) et les broches (3) de contact mâle disposées sur ledit dispositif à semiconducteurs.

9. Matériau composite dans lequel des pellicules de métal minces sont empilées et solidarisées, dans lequel les pellicules de métal minces comprennent une pluralité de pellicules de cuivre, d'argent, d'or ou d'aluminium sensiblement pur en alternance avec au moins une pellicule d'un matériau doué de mémoire de forme.

10. Matériau composite dans lequel des pellicules de métal minces sont empilées et solidarisées, dans lequel les pellicules de métal minces comprennent une pluralité de pellicules d'un matériau ferromagnétique en alternance avec au moins une pellicule d'un matériau doué de mémoire de forme.

11. Matériau selon la revendication 9 ou la revendication 10, dans lequel une pluralité de matériaux doués de mémoire de forme à points de transformation différents sont empilés.

FIG. 1

(a)

(b)

(c)

(d)

(e)

FIG. 2

(a)

(b)

(c)

(d)

1

FIG. 3

(a)    (b)

FIG. 4

FIG. 5

(a)

(b)

FIG. 6

FIG. 7

FIG. 8

FIG. 9

*FIG.* 10

*FIG.*11

*FIG.*12

*FIG.*13

*FIG.*14

4

# FIG.15